(19) **Europäisches Patentamt**
**European Patent Office**
**Office européen des brevets**

(11) **EP 2 924 598 A1**

(12) **EUROPEAN PATENT APPLICATION**

(43) Date of publication:
**30.09.2015 Bulletin 2015/40**

(51) Int Cl.:
***G06F 17/50*** (2006.01)

(21) Application number: **14162514.5**

(22) Date of filing: **28.03.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
• **Airbus Operations GmbH**
  **21129 Hamburg (DE)**
• **DLR Deutsches Zentrum für Luft- und Raumfahrt e.V.**
  **51147 Köln (DE)**

(72) Inventors:
• **Quero-Martin, David**
  **22767 Hamburg (DE)**
• **Jenaro Rabadan, Guillermo**
  **22605 Hamburg (DE)**

(74) Representative: **UEXKÜLL & STOLBERG**
**Patentanwälte**
**Beselerstrasse 4**
**22607 Hamburg (DE)**

(54) **A method for determining a structural response of a flow body to an atmospheric disturbance**

(57) The intention relates to a method for determining a structural response of a flow body to an atmospheric disturbance of interest. In frequency domain, for each of a plurality of frequencies $k$, a matrix $Q(k)$ is determined and a relationship relating downwash $W_j^{\,g}$ caused by atmospheric disturbance g to an estimate of a corresponding structural responses $U_h$ via the matrix $Q(k)$ is established. At least one test atmospheric disturbance profile and, for each of these profiles, at least one assumed structural response is provided. Then, for each test atmospheric disturbance profile and for each of respective assumed structural response the downwash $W_j^{\,g}$ caused by the test atmospheric disturbance profile and the downwash caused by the respective assumed structural response to determine a combined downwash $W_j$. A CFD computation of at least one aerodynamic quantity, which is a function of the combined downwash and the matrix $Q(k)$ and which results when the flow body is subjected to the respective test atmospheric disturbance profile and the flow body is moving in accordance with the respective assumed structural response is performed and the result transformed into the frequency domain. A set of corrected matrices $Q(k)'$ is determined by correcting the matrices $Q(k)$ such that the value of the at least one aerodynamic quantity computed by the CFD computation matches the value of the at least one aerodynamic quantity calculated by the function. For the atmospheric disturbance of interest a structural response using the relationship and one of the determined sets of corrected matrices $Q(k)'$ or a set of matrices $Q(k)'$ obtained by interpolation of at least one of the determined sets of corrected matrices $Q(k)'$ is calculated.

Fig. 1

EP 2 924 598 A1

**Description**

The present application relates to a method applied in the field of aeroelasticity. In particular, it relates to a method for determining a structural response of a flow body to an atmospheric disturbance of interest having a defined flow profile, such as a gust of interest having a defined gust profile.

The field of aeroelasticity concerns the interaction between the aerodynamics and the mechanics of the elastic structure of a flow body subjected to aerodynamic loads. In other words, the elastic structural response of a flow body to a certain flow impinging on the flow body is investigated.

Gust analysis plays an important role in modern aircraft design. The Federal Aviation Regulations (FAR) in the USA or equivalent regulations in other countries in particular specify the discrete gust and continuous gust design criteria to which the aircraft must be subjected for certification. Conventionally, the dynamic response of an aircraft subject to a discrete gust has been analyzed or predicted by potential flow panel methods in the frequency domain. If time domain solutions are required, then some numerical technique such as the rational function approximation method may be employed for conversion from frequency domain to time domain. In the transonic regime, the computational fluid dynamics (CFD) methodology possesses advantages over the potential flow panel methods, because it is capable of taking into consideration shock wave effects and provides increased compressive flow solution accuracy. In the so called "Field Velocity" method the gust velocities are assigned to the CFD grids' velocity components without actually moving the grids. Considering the fact that the discrete gust is modeled as a traveling gust, this has the consequence that, at every moment, the gust velocity component at each CFD grid needs to be updated according to the gust profile at the current time. The number of CFD grids can be enormous and easily reach tens of thousands, so that the time needed for performing the computations is a problem for the "Field Velocity" method during gust analysis.

Practical methods known in the art for determining a structural response of a flow body to a certain gust profile are based on the so called gust equation. The gust equation provides a relationship between the gust profile on the one hand, and the structural response of the flow body caused by said gust profile when impinging on the flow body on the other hand. The relationship is defined by aerodynamic influence coefficients which in the case of a multidimensional relationship are applied in the form of a matrix, the aerodynamic influence coefficient (AIC) matrix $Q$. Said aerodynamic influence coefficient (AIC) matrix $Q$ can be determined by various methods known in the art, such as the Doublet Lattice Method (DLM) solved by means of an adequate software, such as Nastran.

The AIC matrix $Q$ relates the downwash at a control point to forces or pressures at an acting point. This AIC matrix is particularly suitable for time domain simulations, since it has to be computed only once for each Mach number in advance and can be used later on for actual calculations. In this regard, the varying forces during a dynamic simulation can be calculated by multiplication of the AIC matrix with the downwash vectors at the control point that are computed from the rigid body and elastic motions. The computation of the aerodynamic loading reduces to a mere matrix multiplication. The AIC matrix may be transformed into frequency domain in order to solve the gust equation in frequency domain, wherein the AIC matrix $Q(k)$ depends on frequency $k$.

The AIC matrix $Q(k)$ in general is based on a linearized description of the flow, i.e. the flow equations. However, this approximation does not apply in all flow regimes and cases.

For example, in transonic flow condition non-linearities such as compression shocks and flow separation render the governing equations non-linear. Thus, for a wide range of atmospheric disturbance profiles the AIC matrix $Q(k)$ itself does not depend on the atmospheric disturbance profile, so that the gust equation forms a linear relationship and the AIC matrix is applicable. The linear relationship provides sufficiently precise results for these cases. However, for other flow regimes and atmospheric disturbance profiles the results for the structural response obtained by using the linear relationship are not precise enough compared to e.g. results obtained by a Computational Fluid Dynamics (CFD) simulation.

For such nonlinear cases the common aerodynamic influence coefficient (AIC) matrix $Q(k)$ as applied in the linear relationship cannot be used to achieve satisfying results. Alternatively, a CFD/CSM (Computational Structure Mechanics) simulation, i.e. a real time simulation coupling simultaneously the flow and the structure, can be set up which may provide good results for nonlinear flow cases, depending on the respective model on which the CFD/CSM simulation is based. However, a non-linear CFD/CSM simulation would be very complex.

Therefore, the object of the present invention is to provide a method for determining a structural response of a flow body to a certain atmospheric disturbance, which provides more precise results also in cases in which the linearized approximation of the flow equations does not apply, and which can be carried out in practical time periods.

This object is achieved by a method for determining a structural response of a flow body to a atmospheric disturbance of interest having a defined atmospheric disturbance profile, wherein said method comprises the following steps.

First, a matrix $Q(k)$ is determined for the flow body in frequency domain for each of a plurality of frequencies $k$, which matrix is a linear transfer matrix defining a linear relation between the pressure over the surface panels of a flow body and the downwash transverse to these panels, and which can be applied to describe a relation between the atmospheric disturbance profile and the structural response. Thus, multiplication of the downwash distribution with the matrix $Q(k)$ yields, in frequency domain, the pressure distribution over the surface panels of the flow body or one or more aerodynamic quantities depending itself on the pressure distribution. In particular, the matrix $Q(k)$ can be an aerodynamic influence coefficient (AIC) matrix. This determining of the matrix $Q(k)$ can be done by a known method such as DLM, using e.g. Nastran software. The structural response may be a structural deformation and/or a rigid body movement.

Subsequently, a relationship relating in frequency domain and for each of the plurality of frequencies $k$ downwash $W_j^g$ caused by an atmospheric disturbance g - such as a gust - impinging on the flow body to an estimate of a corresponding structural *responses* $U_h$ of the flow body via the matrix $Q(k)$ is established. Here, downwash $W_j^g$ caused by atmospheric disturbance represents the downwash generated at each of a plurality of points j of the flow body when the flow body is subjected to a respective atmospheric disturbance profile g, and structural *response* $U_h$ represents the structural response for $h$ degrees of freedom. Downwash is the normal fluid velocity component, i.e. the fluid velocity component normal to the surface of the flow body at a particular location. In particular, the downwash is the normal fluid perturbation velocity component.

As a next step, one or more test atmospheric disturbance profiles are provided, which may be, for example, test gust profiles. Each of the one or more test atmospheric disturbance profiles may be any atmospheric disturbance profile within a range of interest. In the preferred case of more than one test atmospheric disturbance profile, profiles of different lengths and/or amplitudes may be advantageously used, for example 1-cosine gusts of different lengths and/or amplitudes. Then, for each of the test atmospheric disturbance profiles at least one assumed structural response of the flow body is determined, each of which may be the zero or a non-zero structural response. The assumed structural response can be simply selected, estimated, or determined through a specific calculation or in an empirical manner.

Subsequently, for each of the at least one test atmospheric disturbance profile and for each of the respective at least one assumed structural response the downwash $W_j^g$ caused by the respective test atmospheric disturbance profile and the downwash caused by the respective assumed structural response is combined, i.e. added, in order to determine a combined downwash $W_j$. The downwash can be calculated in a well-known manner based on the geometry of the flow body, e.g. by determining the well-known so-called substantial derivative matrix, which relates downwash to structural response, from the geometry of the flow body and using the substantial derivative matrix to determine the downwash by multiplying it with the structural response vector.

Further, a CFD computation of at least one aerodynamic quantity is performed. The at least one aerodynamic quantity is a function of the respective test atmospheric disturbance profile and the respective assumed structural response. Examples for the at least one aerodynamic quantity are total lift or moment of the entire flow body or local lift or moment of only a geometric section or station on the surface of the flow body, or the pressure over such a section or station of the flow body. Then, the result of the computation is transformed into the frequency domain. This can be done e.g. by a Fast Fourier Transformation (FFT).

Subsequently, for each of the at least one test atmospheric disturbance profile and for each of the respective at least one assumed structural response a set of corrected matrices $Q(k)'$ is determined by correcting at each of the plurality of *frequencies k* the matrix $Q(k)$ such that the value of the at least one aerodynamic quantity computed by the CFD computation matches the value of the at least one aerodynamic quantity calculated by the function, for example by a least square process. This is possible because the functional relationship between the result of the CFD computation, i.e. the at least one aerodynamic quantity calculated by the CFD computation, on the one hand and test atmospheric disturbance profile and assumed structural response on the other hand includes a matrix having the same units and dimensions as the matrix $Q(k)$, and the corrected matrix $Q(k)'$ is made to be identical to or approximate that matrix. In other words, for each of the plurality of *frequencies k* a matrix $Q(k)'$ is determined which is part of the function. Preferably, for each of the plurality of *frequencies k* the matrix $Q(k)'$ is such that when a matrix $A(k)Q(k)'B(k)$ with matrices $A(k)$ and $B(k)$, one or both of which may be the identity matrix, is multiplied with the combined downwash $W_j$, the result of the CFD computation is matched. Then, the function involves, for each frequency k, the matrix $A(k)Q(k)'B(k)$ and its multiplication with the combined downwash. In the preferred case in which the uncorrected matrix $Q(k)$ and the corrected matrix $Q(k)'$ relate to the pressure distribution, the matrices $A(k)$ and $B(k)$ serve to modify the matrix $Q(k)'$ such that instead of a pressure distribution the desired aerodynamic quantity or quantities result and can be easily determined, and in other cases they serve to modify the matrix $Q(k)'$ such that desired (aerodynamic) quantities result. It should be noted that the matrix $A(k)Q(k)B(k)$, i.e. using the uncorrected matrix $Q(k)$ may be used for the same calculation, but the result will generally not match the correct result of the CFD computation, because the determination of the uncorrected matrix $Q(k)$, such as the AIC matrix, is based on linear approximations, and the matching step is done to minimize these differences.

As a final step, for the atmospheric disturbance of interest a structural response is calculated using the relationship and one of the determined sets of corrected matrices $Q(k)'$ or a set of matrices $Q(k)'$ obtained by interpolation on the basis of one or more of the determined sets of corrected matrices $Q(k)'$.

In such a manner the matrices $Q(k)$ of the linear relationship between the specific atmospheric disturbance profile and the structural response are corrected by the results of a nonlinear CFD simulation for certain combinations of atmospheric disturbance profiles and structural responses, so that the respective corrected matrices $Q(k)'$ can be used to determine the structural response by the gust equation also in the case of a nonlinear relationship. A database for the results of the CFD simulation, i.e. the aerodynamic quantities in terms of the test atmospheric disturbance profile and the assumed structural response, is generated for a variety of nonlinear cases, and between these results an interpolation is carried out, so that for a continuous range of aerodynamic quantities and non-linear cases corrected matrices $Q(k)'$ are available.

According to a preferred embodiment, for each of the at least one test atmospheric disturbance profile only one assumed structural response is determined by calculating the assumed structural response for the respective test atmospheric disturbance profile by means of the relationship, i.e. the linear gust equation comprising the uncorrected matrices $Q(k)$.

According to an alternative embodiment for each of the at least one test atmospheric disturbance profile a plurality of different assumed structural responses are specified, which may be respectively the zero structural response or a non-zero structural response. In this regard it is to be noted that embodiments are possible in which for each of a plurality of different profiles only the zero structural response is used. In particular, profiles having different amplitudes but an identical length may be used, for example, instead of different structural responses for a single profile of the particular length. The step of determining a set of corrected matrices $Q(k)'$ comprises associating the set of corrected matrices $Q(k)'$ with the respective combined downwash $W_j$, i.e. each set of corrected matrices $Q(k)'$ can be identified by the respective combined downwash $W_j$. However, as will be explained in more detail below, different combined downwashes $W_j$ may have identical corrected matrices $Q(k)'$, so that a particular combined downwash $W_j$ may not identify unambiguously only one set of corrected matrices $Q(k)'$.

In this embodiment, the step of calculating for the atmospheric disturbance of interest a structural response comprises a) specifying an initial combined downwash $W_j^{i=0}$ which is identical to the downwash $W_j^g$ caused by the atmospheric disturbance profile of interest and corresponding to zero structural response $U_h^{i=0}$, b) obtaining a set of corrected matrices $Q(k)''$ corresponding to the atmospheric disturbance profile of interest and the combined downwash $W_j^i$ by means of interpolation of at least one and preferably at least two of the plurality of sets of corrected matrices $Q(k)'$ for the different test atmospheric disturbance profiles and combined downwashes $W_j$, c) determining for the atmospheric disturbance profile of interest a structural response $U_h^{i+1}$ using the relationship and the set of corrected matrices $Q(k)''$ determined in step b), d) combining the downwash $W_j^g$ caused by the respective test atmospheric disturbance profile and the downwash caused by the structural response $U_h^{i+1}$ determined in step c) to determine a combined downwash $W_j^{i+1}$, e) determining whether the difference between the combined downwashes $W_j^{i+1}$ and $W_j^i$ determined in steps b) and d) and/or the difference between the structural responses $U_h^{i+1}$ and $U_h^i$ does not exceed a predetermined tolerance criteria, and f) taking the structural response $U_h^{i+1}$ as result of the calculating step if the predetermined tolerance criteria is not exceeded, or otherwise specifying a combined downwash $W_j^{i+1}$ which is identical to the downwash $W_j^g$ caused by the atmospheric disturbance profile of interest and the downwash caused by the structural response $U_h^{i+1}$ determined in step d) and repeating steps b) to f).

In such a manner a considerably more precise value of the combined downwash $W_j^{i+1}$ can be determined by an iteration, leading to a possibly more precise value of the structural response $U_h^{i+1}$.

In a preferred embodiment the combined downwashes $W_j$ associated with the sets of corrected matrices $Q(k)'$ and the combined downwashes $W_j^i$ are identified by a single combined downwash identification parameter, in the present application referred to as equivalent downwash. This identification parameter is a single absolute value which identifies distributions of the combined downwash $W_j^i$. In this regard, the combined downwashes $W_j$ associated with the sets of corrected matrices $Q(k)'$ and the combined downwashes $W_j^i$ are identified by the single combined downwash identification parameter, which is defined in such a manner that when the corresponding combined downwash $W_j^i$ is multiplied with the matrix $Q(k)'$, preferably the AIC matrix, the same value of the respective aerodynamic quantity results. The equivalent downwash is used instead of the corresponding "full" downwash for identifying the matrix or matrices to be used for the the interpolation in step b).

In a preferred embodiment the matching step comprises a least squares process.

In yet another preferred embodiment the at least one test atmospheric disturbance profile is a 1-cosine atmospheric disturbance profile. Another harmonic profile, such as e.g. a sine profile may also be used.

According to a further preferred embodiment the at least one aerodynamic quantity is local lift or local moment at multiple different geometrical stations. It may also be the total lift or moment over all the geometrical stations, i.e. over the entire flow body.

According to a preferred embodiment the flow body is an airfoil, such as a wing of an aircraft, and the atmospheric disturbance profiles are the atmospheric disturbance profiles impinging onto the airfoil during flight of the respective aircraft.

Any atmospheric disturbance mentioned in the present application may be, e.g., a gust or a wake vortex, or may be related to a movement of the flow body induced by the flight control system.

In a preferred embodiment the method is carried out automatically or semiautomatically, e.g. by utilizing suitable processing or computing means.

A further aspect of the present invention relates to a data carrier on which computer readable instructions are stored which, when executed by a computer, carry out a method according to any of the embodiments described before.

Yet a further aspect of the present invention relates to a system comprising a data carrier as described before, and a computer adapted to execute the instructions stored on the data carrier, preferably in an automatic or semiautomatic manner.

In the following an embodiment of the invention is described in more detail with reference to a Figure.

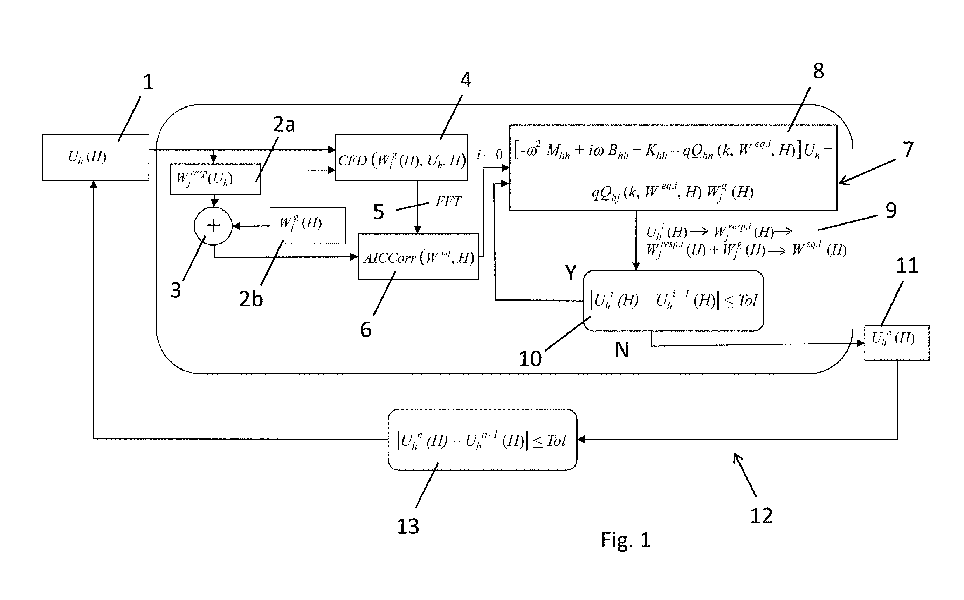

Figure 1 shows a flow chart of a method for determining a structural response in accordance with the invention.

The method illustrated in the Figure is configured to determine for a flow body a structural *response* $U_h$ in the form of a structural deformation and a rigid body motion for a 1-cosine atmospheric disturbance g having a length defined by the variable $H$, which may be, e.g., the half length of the atmospheric disturbance or gradient of atmospheric disturbance. For example, the atmospheric disturbance g may be a gust. This structural response $U_h$ is generally determined using the linear equation

$$[-\omega^2 M_{hh} + i\omega B_{hh} + K_{hh} - qQ_{hh}(k)]U_h = qQ_{hj}(k)W_j^g \qquad (1)$$

where $\omega$ is frequency, $k$ is reduced frequency, $M_{hh}$ is a mass matrix describing the flow body, $B_{hh}$ is a damping matrix describing the flow body, $K_{hh}$ is a stiffness matrix describing the flow body, $Q_{hh}$ and $Q_{hj}$ are frequency dependent matrices which are products of a matrix $Q(k)$ describing the flow body and other matrices, and $W_j^g$ is the downwash caused or generated by the atmospheric disturbance g at each of a plurality of points $j$ of the flow body when the flow body is subjected to the atmospheric disturbance g. This linear equation may also be referred to as gust equation. The structural response $U_h$ is expressed in different coordinates corresponding to h suitable degrees of freedom, such as modal degrees of freedom.

Prior to actually utilizing equation (1), which - as such - only provides a linear approximation, which does not provide correct results in situations in which non-linear effects have to be taken into consideration, a database of corrected matrices $Q(k)'$ is established and used later-on in order to incorporate the non-linearities without having to dispense with equation (1) and the well-established structural model of the flow body on which it is based.

For this purpose, multiple different 1-cosine test atmospheric disturbance profiles g characterized by different lengths H are provided. For each of these test atmospheric disturbance profiles g several structural responses having different amplitudes are imposed, which are selected in a suitable manner as will be explained in more detail below. Each combination of a particular test atmospheric disturbance profile g and a particular imposed structural response produces a particular downwash distribution changing both in time and spatially, and this downwash distribution is related in a linear manner via the matrices $Q(k)$ to various aerodynamic quantities such as local lift.

In this regard, it has been found that the rather complex full downwash distributions can be sufficiently identified by e.g. the maximum downwash a panel sees over time, and this maximum downwash will be referred to as "equivalent downwash" $W^{eq}$, because any downwash distribution corresponding to the same equivalent downwash $W^{eq}$ is equivalent for the purposes of the following method steps. In other words, once a calculation has been made for a downwash distribution having a particular equivalent downwash $W^{eq}$ it is not necessary to repeat the calculation for a different downwash distribution having the same equivalent downwash $W^{eq}$. Other definitions of the equivalent downwash $W^{eq}$, such as e.g. an averaged value of the downwash a panel sees over time, can also be applied depending on the specific problem or model. However, the equivalent downwash always remains a scalar value.

Thus, in step 1, for each test atmospheric disturbance profile an imposed structural *response* $U_h$ is selected.

Then, for each test atmospheric disturbance and each corresponding imposed structural *response* $U_h$ the downwash $W_j^{resp}(U_h)$ caused by the respective imposed structural response is calculated in step 2a and is combined in step 3 with the downwash $W_j^g(H)$ (see box 2b) caused by the respective test atmospheric disturbance profile to determine a respective combined downwash distribution $W_j$. In the above manner, the equivalent downwash $W^{eq}$ is then determined for each such combined downwash distribution $W_j$.

Then, for each test atmospheric disturbance profile and each corresponding imposed structural response a CFD calculation of local lift is carried out in step 4, and the result is transformed into frequency domain by means of FFT 5.

On the other hand, in step 6 for each test atmospheric disturbance profile and each corresponding imposed structural response, i.e. for each of the CFD calculations, a set of corrected matrices $Q(k)'$, and thus also corrected matrices $Q_{hh}$ and $Q_{hj}$, is determined by correcting at each of the plurality of *frequencies k* the matrices $Q(k)$ such that the value of the local lift computed by CFD matches the value of the local lift calculated in the above linear manner using the matrices $Q(k)'$. Importantly, the corrected sets of matrices $Q(k)'$ depend on the atmospheric disturbance length H and the equivalent downwash $W^{eq}$, so that the same corrected matrices $Q(k)'$ are valid for different downwash distributions having the same equivalent downwash $W^{eq}$.

Once the data base has been established, it is possible to calculate the deformation $U_h$ for a 1-cosine atmospheric disturbance of arbitrary length H by using the iterative loop 7.

The iterative loop 7 starts with a first iteration, in which the variable i is set to i = 0 and in which some initial structural response $U_h^{i=0}$ is guessed or assumed, such as zero structural response.

Then, in step 8 the corresponding downwash $W_j^g(H)$ caused by the atmospheric disturbance and the corresponding equivalent downwash $W^{eq,i}$ are calculated in the manner described above, a set of corrected matrices $Q(k)'$ - and, thereby, corrected matrices $Q_{hh}(k, W^{eq,i}, H)$ and $Q_{hj}(k, W^{eq,i}, H)$ - is determined using the data base by choosing a set included in the data base for the same equivalent downwash $W^{eq}$ or by interpolation using one or more sets of corrected matrices included in the data base for similar equivalent downwashes $W^{eq}$, and the equation (1) is solved using the determined set of corrected matrices, thereby determining the structural response $U_h^{i+1}$ while also considering non-linearities.

Then, in step 9 a new equivalent downwash $W^{eq,i+1}$ is calculated in the manner described above for the determined structural response $U_h^{i+1}$, and in step 10 it is checked whether the difference or norm between the new structural response $U_h^{i+1}$ and the previous structural response $U_h^i$ exceeds a particular tolerance criterion. In the affirmative, the loop 7 reverts to step 8, wherein the set of corrected matrices is determined using the new equivalent downwash $W^{eq,i+1}$. In this manner, it is guaranteed that eventually the set of corrected matrices used for the calculation of the "final" structural response $U_h$ (see box 11) indeed closely corresponds or matches the equivalent downwash and that, therefore, all non-linearities are taken into consideration.

For the same purpose and to further refine the result, it is possible to use an external iteration loop 12, in which it is determined in step 13 whether the difference between the calculated structural response $U_h$ and the original imposed structural response exceeds a tolerance criterion. In the affirmative, all of the above steps are repeated using the calculated structural response $U_h$. Instead of the entire structural response $U_h$ it is also possible to determine in the same manner the mere structural deformation excluding the simultaneous rigid body motion which forms also part of the structural response $U_h$.

If the norm of the "final" structural response $U_h^n$ differs with respect to the norm of the assumed structural response $U_h^{n-1}$ by more than a specified tolerance, the database of assumed structural responses used for the CFD computations prior to the matrix correction process can be extended by adding this structural response $U_h^n$ to the set of CFD computations. The complete process can be then started again.

**Claims**

1. A method for determining a structural response of a flow body to an atmospheric disturbance of interest having a defined atmospheric disturbance profile, comprising the following steps:

   - determining for the flow body in frequency domain a matrix $Q(k)$ for each of a plurality of frequencies $k$,
   - establishing a relationship relating in frequency domain and for each of the plurality of frequencies k downwash $W_j^g$ caused by atmospheric disturbance g impinging on the flow body to an estimate of a corresponding structural responses $U_h$ of the flow body via the matrix $Q(k)$, wherein downwash $W_j^g$ caused by atmospheric disturbance represents the downwash generated at each of a plurality of points j of the flow body when the flow body is subjected to a respective atmospheric disturbance profile g, and structural response $U_h$ represents the structural response for $h$ degrees of freedom,
   - providing at least one test atmospheric disturbance profile,
   - determining for each of the test atmospheric disturbance profiles at least one assumed structural response of the flow body,
   - for each of the at least one test atmospheric disturbance profile and for each of the respective at least one assumed structural response

      - combining the downwash $W_j^g$ caused by the respective test atmospheric disturbance profile and the downwash caused by the respective assumed structural response to determine a combined downwash $W_j$,
      - performing a CFD computation of at least one aerodynamic quantity, which is a function of the combined downwash and the matrix $Q(k)$ and which results when the flow body is subjected to the respective test atmospheric disturbance profile and the flow body is moving in accordance with the respective assumed structural response, and transforming the result of the computation into the frequency domain,
      - determining a set of corrected matrices $Q(k)'$ by correcting at each of the plurality of frequencies $k$ the matrix $Q(k)$ such that the value of the at least one aerodynamic quantity computed by the CFD computation matches the value of the at least one aerodynamic quantity calculated by the function, and

      - calculating for the atmospheric disturbance of interest a structural response using the relationship and one of the determined sets of corrected matrices $Q(k)'$ or a set of matrices $Q(k)'$ obtained by interpolation of at least one of the determined sets of corrected matrices $Q(k)'$.

2. The method according to claim 1, wherein for each of the at least one test atmospheric disturbance profile only one assumed structural response is determined by calculating the assumed structural response for the respective test atmospheric disturbance profile by means of the relationship.

3. The method according to claim 1, wherein

   - for each of the at least one test atmospheric disturbance profile a plurality of different assumed structural responses are specified including the zero structural response,
   - the step of determining a set of corrected matrices $Q(k)'$ comprises associating the set of corrected matrices $Q(k)'$ with the respective combined downwash $W_j$, and
   - the step of calculating for the atmospheric disturbance of interest a structural response comprises

a) specifying a combined downwash $W_j^{i=0}$ which is identical to the downwash $W_j^g$ caused by the atmospheric disturbance profile of interest and corresponding to zero structural response $U_h^{i=0}$ ,

b) obtaining a set of corrected matrices $Q(k)''$ corresponding to the atmospheric disturbance profile of interest and the combined downwash $W_j^i$ by means of interpolation of at least two of the plurality of sets of corrected matrices $Q(k)'$ for the different test atmospheric disturbance profiles and combined downwashes $W_j$,

c) determining for the atmospheric disturbance of interest a structural response $U_h^{i+1}$ using the relationship and the set of corrected matrices $Q(k)''$ determined in step b),

d) combining the downwash $W_j^g$ caused by the respective test atmospheric disturbance profile and the downwash caused by the structural response $U_h^{i+1}$ determined in step c) to determine a combined downwash $W_j^{i+1}$ ,

e) determining whether the difference between the combined downwashes $W_j^{i+1}$ and $W_j^i$ determined in steps b) and d) and/or the difference between the structural responses $U_h^{i+1}$ and $U_h^i$ does not exceed a predetermined tolerance criteria,

f) taking the structural response $U_h^{i+1}$ as result of the calculating step if the predetermined tolerance criteria is not exceeded, or otherwise specifying a combined downwash $W_j^{i+1}$ which is identical to the downwash $W_j^g$ caused by the atmospheric disturbance profile of interest and the downwash caused by the structural response $U_h^{i+1}$ determined in step d) and repeating steps b) to f).

4. The method according to claim 3, wherein the combined downwashes $W_j$ associated with the sets of corrected matrices $Q(k)'$ and the combined downwashes $W_j^i$ are identified by a single combined downwash identification parameter $W^{eq}$ and $W^{eq,i}$, respectively.

5. The method according to any of the preceding claims, wherein the matching step comprises a least squares process.

6. The method according to any of the preceding claims, wherein the at least one test atmospheric disturbance profile is a 1-cosine atmospheric disturbance profile.

7. The method according to any of the preceding claims, wherein the at least one aerodynamic quantity is local lift or local moment at multiple different geometrical stations.

8. The method according to any of the preceding claims, wherein the flow body is an airfoil.

9. The method according to any of the preceding claims, wherein the atmospheric disturbance of interest and the test atmospheric disturbances are gusts or wake vortices.

10. A data carrier on which computer readable instructions are stored which, when executed by a computer, carry out a method according to any of the preceding claims.

11. A system comprising a data carrier according to claim 10 and a computer adapted to execute the instructions stored on the data carrier.

Fig. 1

$$U_h(H) \quad 1$$

$$W_j^{resp}(U_h) \quad 2a$$

$$+ \quad 3$$

$$W_j^g(H) \quad 2b$$

$$CFD\left(W_j^g(H), U_h, H\right) \quad 4$$

$$FFT \quad 5$$

$$AICCorr\left(W^{eq}, H\right) \quad 6$$

$$i = 0$$

$$\left[-\omega^2 M_{hh} + i\omega B_{hh} + K_{hh} - qQ_{hh}\left(k, W^{eq,i}, H\right)\right]U_h =$$

$$qQ_{hj}\left(k, W^{eq,i}, H\right) W_j^g(H) \quad 7 \quad 8$$

$$U_h^i(H) \rightarrow W_j^{resp,i}(H) \rightarrow$$
$$W_j^{resp,i}(H) + W_j^g(H) \rightarrow W^{eq,i}(H) \quad 9$$

$$\left|U_h^i(H) - U_h^{i-1}(H)\right| \leq Tol \quad 10$$

Y

N

$$U_h^n(H) \quad 11$$

$$12$$

$$\left|U_h^n(H) - U_h^{n-1}(H)\right| \leq Tol \quad 13$$

Europäisches
Patentamt

European
Patent Office

Office européen
des brevets

## EUROPEAN SEARCH REPORT

Application Number

EP 14 16 2514

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ROBERTO G. A. SILVA ET AL: "Investigation on Transonic Correction Methods for Unsteady Aerodynamics and Aeroelastic Analyses", JOURNAL OF AIRCRAFT, vol. 45, no. 6, 1 November 2008 (2008-11-01), pages 1890-1903, XP055135896, ISSN: 0021-8669, DOI: 10.2514/1.33406 * the whole document, in particular chapters II. Aerodynamic Model and III. Pressure-Matching Correction Method * | 1-11 | INV. G06F17/50 |
| A | PING-CHIH CHEN ET AL: "Overset Field-Panel Method for Unsteady Transonic Aerodynamic Influence Coefficient Matrix Generation", AIAA JOURNAL, vol. 42, no. 9, 1 September 2004 (2004-09-01), pages 1775-1787, XP055135903, ISSN: 0001-1452, DOI: 10.2514/1.4390 * the whole document, in particular the first first chapter "Introduction" * | 1-11 | |
| A | US 2012/245903 A1 (STURDZA PETER [US] ET AL) 27 September 2012 (2012-09-27) * paragraph [0071] - paragraph [0082] * | 1-11 | TECHNICAL FIELDS SEARCHED (IPC) G06F |

-/--

The present search report has been drawn up for all claims

| Place of search | Date of completion of the search | Examiner |
|---|---|---|
| Munich | 21 August 2014 | Lerbinger, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 14 16 2514

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | J.-S BAE ET AL: "Effects of structural nonlinearity on subsonic aeroelastic characteristics of an aircraft wing with control surface", JOURNAL OF FLUIDS AND STRUCTURES, vol. 19, no. 6, 1 July 2004 (2004-07-01), pages 747-763, XP055135909, ISSN: 0889-9746, DOI: 10.1016/j.jfluidstructs.2004.04.005 * the whole document, in particular chapter 2.3. Unsteady aerodynamic influence coefficients * | 1-11 | |

TECHNICAL FIELDS
SEARCHED      (IPC)

The present search report has been drawn up for all claims

| Place of search | Date of completion of the search | Examiner |
|---|---|---|
| Munich | 21 August 2014 | Lerbinger, Klaus |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 14 16 2514

This annex lists the patent family members relating to the patent documents cited in  the above-mentioned European search report.
The members are as contained in the European Patent Office EDP file on
The European Patent Office is in no way liable for these particulars which are merely given for the purpose of information.

21-08-2014

| Patent document cited in search report | Publication date | Patent family member(s) | | Publication date |
|---|---|---|---|---|
| US 2012245903  A1 | 27-09-2012 | US | 2012245903 A1 | 27-09-2012 |
|  |  | WO | 2012129526 A2 | 27-09-2012 |

EPO FORM P0459